# EUROPÄISCHE PATENTSCHRIFT

(11) **EP 0 610 331 B1**
(45) Veröffentlichungstag und Bekanntmachung des Hinweises auf die Patenterteilung: **03.06.1998**
(21) Anmeldenummer: 92922439.2
(22) Anmeldetag: 27.10.1992
(51) Int. Cl.: G01N 27/90

(54) **SCHALTUNGSANORDNUNG UND VERFAHREN ZUR ELEKTRISCHEN WIRBELSTROMPRÜFUNG**
CIRCUIT ASSEMBLY AND METHOD FOR ELECTRICAL EDDY-CURRENT TESTING
CIRCUIT ET PROCEDE D'ESSAI PAR COURANT DE FOUCAULT

(30) Priorität: 29.10.1991 DE 4135645
(43) Veröffentlichungstag der Anmeldung: 17.08.1994
(73) Patentinhaber: SIEMENS AKTIENGESELLSCHAFT, 80333 München (DE)
(72) Erfinder: VON BERNUS, Ludwig, D-8551 Hemhofen (DE); ERMERT, Helmut, D-8851 Röttenbach (DE); HIPPLER, Jörg, D-4630 Bochum 7 (DE)
(86) Internationale Anmeldenummer: DE9200894
(87) Internationale Veröffentlichungsnummer: WO9309428

(56) Entgegenhaltungen:
- EP-A- 0 012 665
- EP-A- 0 146 091
- US-A- 3 566 258
- DATABASE WPIL Week 8723, Derwent Publications Ltd., London, GB; AN 87162154

## Beschreibung

Die Erfindung bezieht sich auf eine Schaltungsanordnung und auf ein Verfahren zur elektrischen Wirbelstromprüfung, bei dem wenigstens eine in einer Brückenschaltung angeordnete Meßspule zum Einsatz kommt.

In der elektrischen Wirbelstrom-Meßtechnik sind beispielsweise aus "Nondestructive testing handbook, 2nd edition, vol. 4, Electromagnetic testing, American Society for Nondestructive Testing" Schaltungsanordnungen bekannt, bei denen Meßspulen in Brückenschaltung verwendet werden. Dort ist beispielsweise auf S. 167 und 168 eine Schaltungsanordnung offenbart, bei der die beiden Brückenzweige einer Meßbrücke jeweils mit einer Wechselspannung versorgt werden. Die Amplituden und Phasen dieser Wechselspannungen stehen zueinander in einer festen Beziehung. Die Meßspule ist gemeinsam mit einem veränderbaren Kondensator in einem Brückenzweig der Meßbrücke angeordnet. Im anderen Brückenzweig befindet sich ein veränderbarer Widerstand. Die Brücke wird durch eine Veränderung des Widerstandes und der Kapazität abgeglichen, so daß die Brükkenspannung in der Diagonale zwischen den beiden Brückenzweigen Null wird.

Um eine hohe Prüfempfindlichkeit und Dynamik sowie eine hohe räumliche Auflösung bei der Ortung und Analyse von Fehlern in Prüflingen zu erreichen, ist es erforderlich, die Messungen in einem möglichst großen Frequenzbereich bei vielen, möglichst dicht verteilten diskreten Frequenzwerten durchzuführen.

Bei Meßanordnungen in Brückenschaltung muß jedoch die Meßbrücke für jede ausgewählte diskrete Frequenz erneut abgeglichen werden. Dies erfolgt bei den bekannten Anordnungen durch Stellglieder, beispielsweise Potentiometer, mit denen die in den Brückenzweigen angeordneten veränderbaren passiven Schaltungselemente, beispielsweise ein Widerstand, mechanisch verändert werden.

Brückenschaltungen mit mechanisch veränderbaren Schaltungselementen in den Zweigen der Meßbrücke sind konstruktiv aufwendig und störanfällig. Außerdem ist ein mechanischer Abgleich zeitaufwendig, so daß für ein Prüfprogramm nur wenige diskrete Frequenzen zum Einsatz gelangen können.

Aus der US-A-3,278,839 ist eine Schaltungsanordnung zur elektrischen Wirbelstromprüfung bekannt, bei der ein Abgleich der Meßbrücke automatisch dadurch erfolgt, daß ein in der Meßbrücke angeordneter Thermistor und eine zur Meßspule in Reihe geschaltete Induktivität durch Anlegen externer elektrischer Spannungen gesteuert werden. Dieser Abgleich der Meßbrücke erfolgt sequentiell bei unterschiedlichen Meßfrequenzen.

Aus der US-A-3,566,258 ist es bekannt, einen Abgleich der Meßbrücke dadurch herbeizuführen, daß zur Versorgung der Meßbrücke zwei voneinander unabhängige synchronisierte Spannungsquellen vorgesehen sind.

Aus der EP-A-0 012 665 ist es bekannt, zur Spannungsversorgung einer Meßbrücke für die Wirbelstromprüfung eine Wechselspannung vorzusehen, bei der mehrere diskrete Frequenzen überlagert sind.

Der Erfindung liegt nun die Aufgabe zugrunde, eine Schaltungsanordnung sowie ein Verfahren zur elektrischen Wirbelstromprüfung anzugeben werden, mit denen eine hohe prüftechnische Flexibilität und eine hohe Aussagekraft hinsichtlich der Fehlercharakteristika ermöglicht werden.

Die erstgenannte Aufgabe wird gemäß der Erfindung gelöst mit einer Schaltungsanordnung zur elektrischen Wirbelstromprüfung mit den Merkmalen des Patentanspruches 1.

Da für die Spannungsversorgung der Brücke zwei voneinander unabhängig steuerbare, zueinander synchronisierte Wellenformgeneratoren vorgesehen sind, kann bei vorgegebenem zeitlichen Verlauf und vorgegebener Amplitude der von einem Wellenformgenerator bereitgestellten Versorgungsspannung durch Einstellung und Anpassung des zeitlichen Verlaufs und der Amplitude der vom anderen Wellenformgenerator zur Verfügung gestellten Versorgungsspannung die Brücke abgeglichen werden, so daß die Brückenspannung in der Brückendiagonale verschwindet.

Die Unterschiede in den Amplituden und Phasen bzw. in den zeitlichen Verläufen der beiden Versorgungsspannungen kompensieren dabei Streuungen und Frequenzabhängigkeiten der in den Brückenzweigen befindlichen Schaltelemente wie Kondensatoren, Widerstände und Induktivitäten. Ein mechanischer Abgleich ist nicht mehr erforderlich.

Die relevanten Signalparameter der von einem Signalgenerator bereitgestellten Versorgungsspannung sind unabhängig von den relevanten Signalparametern der vom anderen Signalgenerator bereitgestellten Versorgungsspannung einstellbar. Durch die Synchronisierung der beiden Wellenformgeneratoren wird eine gemeinsame Zeitbasis sichergestellt. Diese gemeinsame Zeitbasis ist erforderlich, um unkontrollierte zeitliche Schwankungen der Phasenbeziehung oder der zeitlichen Beziehung zwischen den beiden Versorgungsspannungen zu verhindern, da diese zu undefinierten Zuständen der Meßbrücke führen können.

In einer bevorzugten Ausführungsform sind die Wellenformgeneratoren jeweils parallel zu den Brückenzweigen geschaltet.

Die Genauigkeit des Abgleichs und somit auch der Messung läßt sich dadurch erhöhen, daß der erste Wellenformgenerator parallel zu einem Brückenzweig geschaltet ist, und daß der zweite Wellenformgenerator zwischen einem Ende des einen Brückenzweiges und einem Ende des anderen Brückenzweiges geschaltet ist.

Die Zweitgenannte Aufgabe wird gemäß der Erfindung gelöst mit einem Verfahren mit den Merkmalen eines der Patentansprüche 6 oder 7.

Da einem einzigen ausgewählten zeitlichen Verlauf einer Versorgungsspannung eine Vielzahl von Frequenzen mit den jeweils zugehörigen Amplituden entspricht, ist durch Anpassung des zeitlichen Verlaufs der anderen Versorgungsspannung ein Abgleich der Brücke über ein ganzes kontinuierliches Frequenzspektrum möglich. Bei der Messung am Prüfling kann dann durch Fourieranalyse der Brückenspannung das Verhalten des Prüflings bei einer Vielzahl von Meßfrequenzen in einem einzigen Meßschritt analysiert werden.

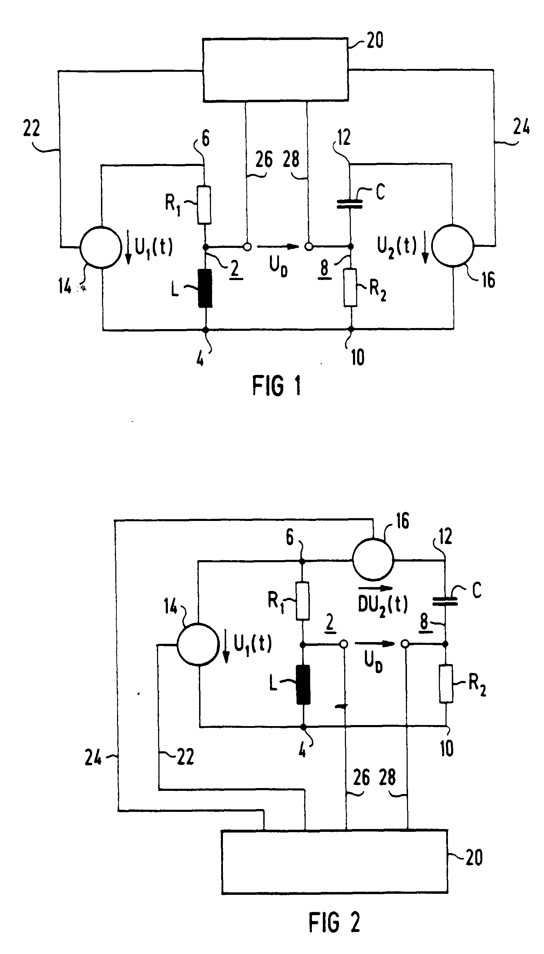

Zur weiteren Erläuterung der Erfindung wird auf die Zeichnung verwiesen, in deren Figuren 1 bis 4 Ausführungsbeispiele von Schaltungsanordnungen gemäß der Erfindung veranschaulicht sind.

Entsprechend **FIG 1** enthält eine Schaltungsanordnung zur elektrischen Wirbelstromprüfung eine Brückenschaltung mit einem ersten und einem zweiten Brückenzweig 2 bzw. 8. Die Brückenzweige 2 und 8 sind an ihren Enden 4, 6 bzw. 10, 12 jeweils an einen Signalgenerator 14 bzw. 16 angeschlossen. Im ersten Brückenzweig 2 sind eine Meßspule L und ein Widerstand R₁ in Serie zueinander geschaltet.

Der zweite Brückenzweig 8 enthält eine Serienschaltung bestehend aus einem Widerstand R₂ und einem Kondensator C. Das der Meßspule L zugeordnete Ende 4 des Brückenzweiges 2 ist mit dem dem Widerstand R₂ zugeordneten Ende 10 des Brückenzweiges 8 kurzgeschlossen. Meßspule L und Kondensator C sind vorzugsweise einander diagonal gegenüber angeordnet, so daß sich die von ihnen verursachten entgegengesetzten Phasenverschiebungen durch geeignete Dimensionierung wenigstens annähernd kompensieren können.

Die zwischen den beiden Brückenzweigen 2 und 8 herrschende Brückenspannung U_{D} wird über Leitungen 26 und 28 einer Steuer- und Auswerteeinheit 20, beispielsweise ein Rechner, zugeführt. Dort wird die Brückenspannung U_{D} erfaßt und ausgewertet.

Die Versorgung der Brückenschaltung erfolgt durch die zwei Signalgeneratoren 14 und 16, mit denen in die Brückenzweige 2 bzw. 8 voneinander verschiedene, jedoch synchronisierte Spannungen U₁(t), U₂(t) eingespeist werden können, da die Enden 6 und 12 der Brückenzweige 2 bzw. 8 nicht kurzgeschlossen sind. Die Signalgeneratoren 14 und 16 sind jeweils steuerbar und über Steuerleitungen 22 bzw. 24 mit der Steuer-und Auswerteeinheit 20 verbunden.

Obwohl nicht Gegenstand der Erfindung wird darauf hingewiesen, daß als Signalgeneratoren 14 und 16 in ihrer Phase und Frequenz unabhängig voneinander steuerbare, jedoch synchronisierte Sinusoszillatoren vorgesehen sein können. In diesem Fall erfolgt der Abgleich der Brücke nacheinander bei unterschiedlichen Meßfrequenzen. Dieser Abgleich kann beispielsweise dadurch erfolgen, daß in den Brückenzweig 2 vom Signalgenerator 14 eine Versorgungsspannung U₁(t)=A₁sin(ω t+φ₁) eingespeist wird. Über die Steuerleitung 24 wird dann die vom Signalgenerator 16 bereitgestellte Versorgungsspannung U₂(t)=A₂sin(ω t+φ₂) in ihrer Amplitude A₂ und Phase φ₂ solange variiert, bis die Brückenspannung U_{D} praktisch gleich Null wird. Durch die Synchronisation ist sichergestellt, daß für beide Sinusoszillatoren dieselbe Zeitbasis t gilt. Die zu diesem Abgleich gehörenden Amplituden- und Phasenwerte A₁, A₂ bzw. φ₁, φ₂ werden dann in der Steuer- und Auswerteeinheit 20 gespeichert. Der Abgleich erfolgt dann sequentiell bei unterschiedlichen Meßfrequenzen ω , wobei für jede Meßfrequenz ω andere Amplituden- und Phasenwerte gespeichert sind. Der Abgleich erfolgt somit rein elektronisch, so daß mechanisch bewegte Stellglieder nicht mehr erforderlich sind. Dadurch kann der Abgleich sehr schnell durchgeführt werden.

Zum Abgleich wird die Meßspule L in Meßposition zu einem fehlerfreien Prüfort gebracht. Dieser fehlerfreie Prüfort kann sich entweder am Prüfling selbst oder an einem Referenzprüfling befinden. Die Wirbelstromprüfung eines möglicherweise fehlerbehafteten Prüflings erfolgt dann dadurch, daß von der Steuer- und Auswerteeinheit 20 nach einander für unterschiedliche Meßfrequenzen ω an die Steuerleitungen 22 und 24 Steuersignale zum Ansteuern der Signalgeneratoren 14 bzw. 16 abgegeben werden, die bewirken, daß die Brückenzweige 2 und 8 mit Sinusspannungen versorgt werden, deren Phasen und Amplituden den Phasen und Amplituden entsprechen, die durch den vorherigen Abgleich ermittelt wurden. Für jede Meßfrequenz ω wird dann die Brückenspannung U_{D} erfaßt und der Auswerte- und Steuereinheit 20 zur Auswertung zugeführt.

Die Schaltungsanordnung gemäß **FIG 2** zeigt eine schaltungstechnische Variante, die gegenüber der Ausführungsform nach FIG 1 einen empfindlicheren Abgleich ermöglicht. In dieser Ausführungsform ist der zweite Signalgenerator 16 an die Enden 6 und 12 zwischen die beiden Brückenzweige 2 und 8 angeschlossen. Diese höhere Empfindlichkeit wird erreicht, weil der Signalgenerator 16 beim Abgleich nur noch eine Versorgungsspannung DU₂(t) bereitstellen muß, die der Differenz der Versorgungsspannungen U₁(t) und U₂(t) des Ausführungsbeispieles gemäß FIG 1 entspricht.

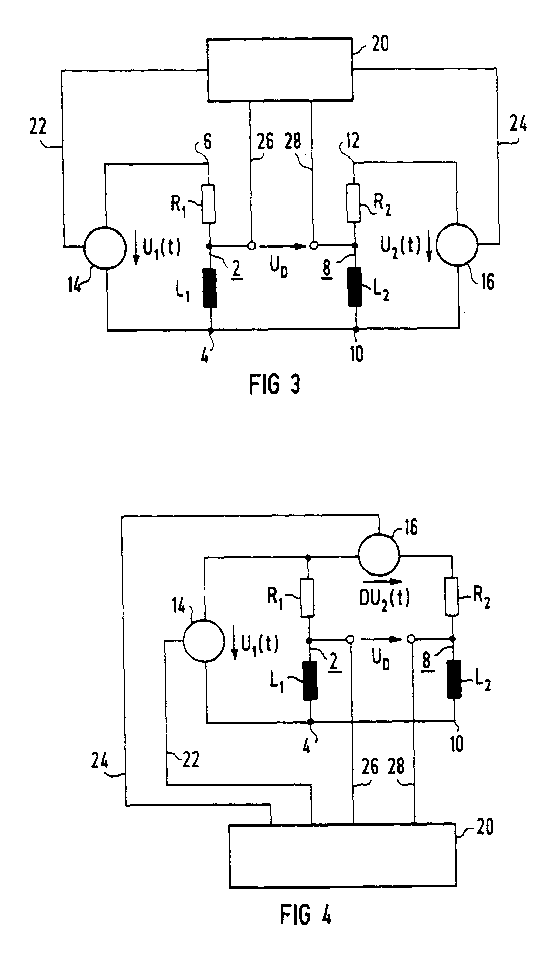

Die Schaltungsanordnungen gemäß **FIG 3** und **FIG 4** sind jeweils analog zu den Schaltungsanordnungen gemäß Figuren 1 bzw. 2. In Abwandlung zu den Ausführungsbeispielen der Figuren 1 und 2 sind jedoch in den Ausführungsbeispielen gemäß Figuren 3 bzw. 4 jeweils Meßspulen L₁ und L₂ in den Brückenzweigen 2 bzw. 8 vorgesehen, so daß sich eine Schaltung mit Differenzsonden ergibt. Außerdem ist im zweiten Brückenzweig 8 der Kondensator C (Figuren 1, 2) durch einen Widerstand R₂ ersetzt. Eine der beiden Meßspulen, beispielsweise die Meßspule L₁ des Brückenzweiges 2, kann dann während der Messung an einen Referenzort, beispielsweise einem fehlerfreien Ort des Prüflings, angekoppelt werden. Dadurch wird der Abgleich der Brückenspannung U_{D} vereinfacht und die Meßgenauigkeit gegenüber den Ausführungsformen gemäß Figuren 1 und 2 nochmals erhöht.

Erfindungsgemäβ sind als Signalgeneratoren 14 und 16 Wellenformgeneratoren vorgesehen, mit denen Spannungssignale mit beliebigem Zeitverlauf erzeugt werden können. Ein vorgegebener Zeitverlauf einer Versorgungsspannung repräsentiert dabei im Frequenzbereich ein kontinuierliches Spektrum mit einem bestimmten Amplituden- und Phasenverlauf über der Frequenz. Nach Wahl einer bestimmten Bandbreite und Realisierung eines entsprechenden Spannungssignals U₁(t), beispielsweise ein Impuls mit einer vorgegebenen Impulsform, insbesondere ein Rechteckimpuls, kann nun zum Abgleich der Brücke eine der beiden Versorgungsspannungen, beispielsweise die Versorgungsspannung U₂(t), in ihrem Zeitverlauf und damit entsprechend nach Amplitude und Phase so modifiziert werden, daß die Brücke breitbandig abgeglichen ist. Auch in diesem Ausführungsbeispiel ist die Impulsform, d.h. der Zeitverlauf der Amplitude innerhalb des Impulses, der einen Versorgungsspannung U₁(t) unabhängig von der Impulsform der anderen Versorgungsspannung U₂(t) einstellbar. Die Versorgungsspannungen U₁(t) und U₂(t) sind synchronisiert, d.h. sie haben eine einheitliche Zeitbasis t. Dies wird bei breitbandigen Wellenformgeneratoren, mit denen in diskreten Zeitabschnitten mit einer Digital-Analog-Wandlung beliebige Signalamplituden entlang der Zeitachse t generiert werden, durch eine Synchronisierung der dieser D/A-Wandlung zugrundeliegenden Takte sichergestellt.

In den Ausgestaltungen nach Figuren 1 bis 4 kann der Abgleich der Brückenschaltung auch während der Messung, d.h. nach Ankopplung der Wirbelstromsonde an eine fehlerbehaftete Stelle des Werkstückes, erfolgen. Durch ein solches Nachführen des Abgleichs wird die Dynamik der Meßeinrichtung erhöht. Bei dieser Ausgestaltung wird die Brückenschaltung jeweils dann neu abgeglichen, wenn die Brückenspannung U_{D} einen vorher festgelegten Wert überschreitet. Die zum Herbeiführen des Abgleichs erforderliche Änderung der Versorungsspannung U₂ des Signalgenerators 16 wird erfaßt und gemeinsam mit der Brückenspannung U_{D} zur Fehlerauswertung herangezogen.

In den Ausführungsbeispielen der Zeichnung sind in den Figuren jeweils Anordnungen dargestellt, bei denen die Brückenzweige jeweils nur eine einzige Meßspule enthalten. Anstelle einer einzigen Meßspule können jedoch in jedem Brückenzweig auch mehrere Meßspulen vorgesehen sein.

## Patentansprüche

1. Schaltungsanordnung zur elektrischen Wirbelstromprüfung mit
a) einer elektrische Brückenschaltung, die zwei Brückenzweige (2, 8) mit jeweils zwei Enden (4, 6 bzw. 10, 12) enthält,
b) mindestens einer wenigstens in einem der Brückenzweige (2, 8) angeordneten Meßspule (L, L₁, L₂),
c) wenigstens einem ersten und einem dazu synchronisierten zweiten unabhängig steuerbaren Wellenformgenerator (14) 16) zur Versorgung der Brückenzweige (2, 8) der Brückenschaltung mit voneinander unabhängigen, in ihrem zeitlichen Verlauf spektral breitbandigen Versorgungsspannungen, die im Frequenzbereich ein kontinuierliches spektrum aufweisen,
c) Mitteln (20) zum Steuern Wenigstens eines dieser Wellenformgeneratoren (14, 16) und
e) Mitteln (20) zum Erfassen und Auswerten der Brückenspannung (U_{D}).

2. Schaltungsanordnung nach Anspruch 1, **dadurch gekennzeichnet,** daß die Wellenformgeneratoren (14, 16) jeweils parallel zu den Brückenzweigen (2 bzw. 8) geschaltet sind.

3. Schaltungsanordnung nach Anspruch 1, **dadurch gekennzeichnet,** daß der erste Wellenformgenerator (14) parallel zu einem ersten Brückenzweig und daß der zweite Wellenformgenerator (16) zwischen einem Ende (6) des ersten Brückenzweiges (2) und einem Ende (12) des zweiten Erückenzweiges (8) geschaltet ist.

4. Schaltungsanordnung nach einem der Ansprüche 1 bis 3, **dadurch gekennzeichnet,** daß ein Ende (4) des ersten Brückenzweiges (2) mit einem Ende (10) des zweiten Brückenzweiges (8) kurzgeschlossen ist.

5. Schaltungsanordnung nach einem der vorhergehenden Ansprüche, **dadurch gekennzeichnet,** daß zum Steuern der Signalgeneratoren (14, 16) und zum Erfassen und Auswerten der Brückenspannung (U_{D}) ein Rechner vorgesehen ist.

6. Verfahren zum Abgleich einer Brückenschaltung für die elektrische Wirbelstromprüfung, bei der in wenigstens einem der Brückenzweige (2, 8) einer Brückenschaltung wenigstens eine Meßspule (L, L₁, L₂) angeordnet ist, mit folgenden Verfahrensschritten:
a) Die Meßspule (L) oder die Meßspulen (L₁, L₂) werden in Meßposition an einen fehlerfreien Referenzort eines Früflings angekoppelt,
b) die Brückenzweige (2, 8) der Brückenschaltung werden gleichzeitig mit zueinander synchronisierten Versorgungsspannungen (U₁(t), U₂(t)) gespeist, von denen mindestens eine unabhängig zeitlich veränderbar ist und deren zeitlicher Verlauf spektral breitbandig ist und im Frequenzbereich ein kontinuierliches Spektrum aufweist,
c) wenigstens eine dieser Versozgungsspannungen (U₂(t)) wird in ihrer Amplitude und in ihrem Zeitverlauf solange geändert, bis die Brückenspännung (U_{D}) wenigstens annähernd verschwindet, und
d) die zeitlichen Verläufe und die Amplituden der beiden Versorgungsspannungen (U₁(t), U₂(t)), bei denen die Brückenspannung (U_{D}) wenigstens annähernd verschwindet, werden gespeichert.

7. Verfahren zur elektrischen Wirbelstromprüfung, bei dem in wenigstens einem Brückenzweig (2, 8) einer Brückenschaltung wenigstens eine Meßspule (L, L₁, L₂) angeordnet ist, mit folgenden Verfahrensschritten:
a) Die Meßspule (L) oder die Meßspulen (L₁, L₂) werden in Meßposition an eine zu überprüfende Stelle des Prüflings angekoppelt,
b) die Brückenzweige (2, 8) der Brückenschaltung werden gleichzeitig mit jeweils unterschiedlichen vorgegebenen, zueinander synchronisierten Versorgungsspannungen (U₁(t), U₂(t)) gespeist, deren zeitlicher Verlauf spektral breitbandig ist und im Frequenzbereich ein kontinuierliches Spektrum aufweist, und
c) die Brückenspannung (U_{D}) wird gemessen und zur Fehlercharakterisierung herangezogen.

8. Verfahren zur elektrischen Wirbelstromprüfung nach Anspruch 7 gekennzeichnet durch Folgende Verfahrensschritte:
a) bei Überschreiten eines vorgegebenen Schwellwertes für die Brückspannung (U_{D}) wird wenigstens eine der Versorgungsspannungen (U₂(t)) in ihrem Zeitverlauf und in ihrer Amplitude solange geändert, bis die Brückenspannung (U_{D}) wenigstens annähernd verschwindet,
b) die zum erneuten Abgleich der Brückenschaltung erforderliche Änderung des Zeitverlaufs und der Amplitude dieser Versorgungsspannung wird erfaßt und gemeinsam mit der Brückenspannung (U_{D}) zur Auswertung herangezogen.

## Claims

1. Circuit arrangement for electrical eddy current testing, having
a) an electrical bridge circuit which includes two arms (2, 8) with in each instance two ends (4, 6 and 10, 12 respectively),
b) at least one measurement coil (L, L₁, L₂) disposed at least in one of the arms (2, 8),
c) at least one first and one second independently controllable wave form generator (14, 16), synchronized therewith, to supply the arms (2, 8) of the bridge circuit with mutually independent, in their temporal progression spectrally wideband supply voltages, which have a continuous spectrum in the frequency range,
d) means (20) for controlling at least one of these wave form generators (14, 16) and
e) means (20) for picking up and evaluating the bridge voltage (U_{D}).

2. Circuit arrangement according to Claim 1, characterized in that the wave form generators (14, 16) are connected in each instance in parallel with the arms (2 and 8 respectively).

3. Circuit arrangement according to Claim 1, characterized in that the first wave form generator (14) is connected in parallel with a first arm, and in that the second wave form generator (16) is connected between one end (6) of the first arm (2) and one end (12) of the second arm (8).

4. Circuit arrangement according to one of Claims 1 to 3, characterized in that one end (4) of the first arm (2) is short-circuited by one end (10) of the second arm (8).

5. Circuit arrangement according to one of the preceding claims, characterized in that a computer is provided to control the signal generators (14, 16) and to pick up and evaluate the bridge voltage (U_{D}).

6. Method for balancing a bridge circuit for electrical eddy current testing, in which at least one measurement coil (L, L₁, L₂) is disposed in at least one of the arms (2, 8) of a bridge circuit, having the following method steps:
a) the measurement coil (L) or the measurement coils (L₁, L₂) are coupled in the measuring position to a defect- free reference location of a test specimen,
b) the arms (2, 8) of the bridge circuit are simultaneously powered with two mutually synchronized supply voltages (U₁(t), U₂(t)), at least one of which is independently temporally variable and the temporal progression of which is spectrally wideband and has a continuous spectrum in the frequency range,
c) at least one of these supply voltages (U₂(t)) is varied in its amplitude and in its temporal progression until such time as the bridge voltage (U_{D}) at least approximately vanishes, and
d) the temporal progressions and the amplitudes of the two supply voltages (U₁(t), U₂(t)), at which the bridge voltage (U_{D}) at least approximately vanishes, are stored.

7. Method for electrical eddy current testing, in which method at least one measurement coil (L, L₁, L₂) is disposed in at least one arm (2, 8) of a bridge circuit, having the following method steps:
a) the measurement coil (L) or the measurement coils (L₁, L₂) are coupled in the measuring position to a position to be tested of the test specimen,
b) the arms (2, 8) of the bridge circuit are simultaneously powered with in each instance different predetermined, mutually synchronized supply voltages (U₁(t), U₂(t)), the temporal progression of which is spectrally wide-band and has a continuous spectrum in the frequency range, and
c) the bridge voltage (U_{D}) is measured and is utilized for defect characterization.

8. Method for electrical eddy current testing according to Claim 7, characterized by the following method steps:
a) if a predetermined threshold value for the bridge voltage (U_{D}) is exceeded, at least one of the supply voltages (U₂(t)) is varied in its temporal progression and in its amplitude until such time as the bridge voltage (U_{D}) at least approximately vanishes,
b) that variation of the temporal progression and of the amplitude of this supply voltage which is required for the rebalancing of the bridge circuit is picked up and utilized, in common with the bridge voltage (U_{D}), for evaluation.

## Revendications

1. Montage destiné au contrôle par courants de Foucault, et comprenant :
a) un circuit électrique en pont, qui comporte deux branches de pont (2, 8) ayant chacune deux extrémités (respectivement 4, 6 et 10, 12),
b) au moins une bobine de mesure (L, L₁, L₂) placée dans au moins l'une des branches de pont (2, 8),
c) au moins un premier et un second générateurs de formes d'onde (14, 16) , propres à être commandés indépendamment l'un de l'autre et synchronisés, le second sur le premier, afin de fournir, aux branches de pont (2, 8) du circuit en pont, des tensions d'alimentation, indépendantes l'une de l'autre, à large bande spectrale quant à leur variation temporelle, et présentant un spectre continu dans la gamme de fréquences,
d) des moyens (20) servant à commander au moins l'un de ces générateurs de formes d'onde (14, 16), et
e) des moyens (20) servant à détecter et à exploiter la tension de pont (U_{D}).

2. Montage selon la revendication 1, caractérisé par le fait que les générateurs de formes d'onde (14, 16) sont chaque fois montés en parallèle avec les branches de pont (respectivement 2, 8).

3. Montage selon la revendication 1, caractérisé par le fait que le premier générateur de formes d'onde (14) est monté en parallèle avec une première branche de pont et que le second générateur de formes d'onde (16) est monté entre une extrémité (6) de la première branche de pont (2) et une extrémité (12) de la seconde branche de pont (8).

4. Montage selon l'une des revendications 1 à 3, caractérisé par le fait qu'une extrémité (4) de la première branche de pont (2) est court-circuitée par une extrémité (10) de la seconde branche de pont (8).

5. Montage selon l'une des revendications précédentes, caractérisé par le fait qu'il est prévu un ordinateur pour la commande des générateurs de signaux (14, 16) ainsi que pour la détection et l'exploitation de la tension de pont (U_{D}).

6. Procédé destiné à l'équilibrage d'un circuit en pont pour le contrôle par courants de Foucault, au moins une bobine de mesure (L, L₁, L₂) étant prévue dans au moins l'une des branches de pont (2, 8) d'un circuit en pont, le procédé comportant les étapes suivantes :
a) la bobine de mesure (L) ou les bobines de mesure (L₁, L₂) sont reliées, en position de mesure, à un endroit de référence, exempt de défauts, d'une pièce à contrôler,
b) les branches de pont (2, 8) du circuit en pont reçoivent simultanément des tensions d'alimentation (U₁(t), U₂(t)) synchronisées l'une par rapport à l'autre, au moins l'une d'elles pouvant être modifiée indépendamment dans le temps et sa variation temporelle étant à large bande spectrale et présentant un spectre continu dans la gamme de fréquences,
c) au moins l'une (U₂(t)) de ces tensions d'alimentation est modifiée quant à son amplitude et à sa variation temporelle jusqu'à ce que la tension de pont (U_{D}) disparaisse, du moins approximativement, et
d) les variations temporelles et les amplitudes des deux tensions d'alimentation (U₁(t), U₂(t)), pour lesquelles la tension de pont (U_{D}) disparaît, du moins approximativement, sont enregistrées en mémoire.

7. Procédé de contrôle par courants de Foulcault, dans lequel au moins une bobine de mesure (L, L₁, L₂) est placée dans au moins une branche de pont (2, 8) d'un circuit en pont, le procédé comprenant les étapes suivantes :
a) la bobine de mesure (L) ou les bobines de mesure (L₁, L₂) sont reliées, en position de mesure, à un emplacement à contrôler de la pièce soumise au contrôle,
b) les branches de pont (2, 8) du circuit en pont reçoivent simultanément des tensions d'alimentation (U₁(t), U₂(t)), prédéfinies, chaque fois différentes, synchronisées l'une par rapport à l'autre, dont la variation temporelle est à large bande spectrale et présente un spectre continu dans la gamme de fréquences, et
c) la tension de pont (U_{D}) est mesurée et prise en compte pour la caractérisation des défauts.

8. Procédé de contrôle par courants de Foucault selon la revendication 7, caractérisé par les étapes suivantes :
a) lors du dépassement d'une valeur prédéfinie de seuil pour la tension de pcnt (U_{D}), au moins l'une (U₂(t)) des tensions d'alimentation est modifiée quant à son amplitude et à sa variation temporelle jusqu'à ce que la tension de pont (U_{D}) disparaisse, du moins approximativement,
b) la modification, requise pour un nouvel équilibrage du circuit en pont, de la variation temporelle et de l'amplitude de cette tension d'alimentation est détectée et prise en compte, en même temps que la tension de pont (U_{D}) pour l'exploitation.
